# EUROPÄISCHE PATENTSCHRIFT

(11) **EP 0 683 520 B1**
(45) Veröffentlichungstag und Bekanntmachung des Hinweises auf die Patenterteilung: **05.12.2001**
(21) Anmeldenummer: 95106296.7
(22) Anmeldetag: 27.04.1995
(51) Int. Cl.: H01L 23/66, H01L 23/482

(54) **Verfahren zur Herstellung einer Anordnung zur Kontaktierung von planaren Hochfrequenzleitungen und Anordnung zur Kontaktierung von planaren Hochfrequenzleitungen**
Method for making a contact device for planar high frequency leads and contact device for planar high frequency leads
Procédé de fabrication d'un dispositif de contact pour conducteurs planaires de haute fréquence et dispositif de contact pour conducteurs planaires de haute fréquence

(30) Priorität: 13.05.1994 DE 4416980
(43) Veröffentlichungstag der Anmeldung: 22.11.1995
(73) Patentinhaber: ROBERT BOSCH GMBH, 70442 Stuttgart (DE)
(72) Erfinder: Bischof, Werner, Dr., D-71522 Backnang (DE); Kuke, Albrecht, Dr., D-71549 Auenwald (DE); Hauer, Heiner, D-70743 Fellbach (DE); Scholz, Werner, D-71544 Weissach i.T. (DE)

(56) Entgegenhaltungen:
- EP-A- 0 001 707
- DE-A- 2 810 054
- DE-A- 3 930 621
- FR-A- 2 565 030
- US-A- 3 747 202
- US-A- 4 189 342
- PATENT ABSTRACTS OF JAPAN vol. 007, no. 226 (E-202), 7.Oktober 1983 & JP 58 115842 A (FUJITSU KK), 9.Juli 1983,

## Beschreibung

Die Erfindung betrifft ein Verfahren zur Herstellung einer Anordnung zur Kontaktierung von planaren Hochfrequenzleitungen mit elektronischen Bauelementen, sowie eine Anordnung zur Kontaktierung von planaren Hochfrequenzleitungen mit elektronischen Bauelementen.

Während bei niedrigen Frequenzen oder bei DC-Anwendungen einfache Kontaktnadeln zur Kontaktierung ausreichen, die nur genügend fein entsprechend den Kontaktabständen auf dem Chip sein müssen, müssen bei HF-Anwendungen die Übertragungseigenschaften der Zuleitungen bis zu den Kontakten auf dem Chip bezüglich ihres Wellenwiderstandes optimiert werden. Nach dem Stand der Technik werden hierzu planare HF-Leitungen auf einem Adaptersubstrat aus Aluminiumoxid-Keramik verwendet, die beispielsweise als Microstrip-Leitungen ausgeführt sind, bei denen die Rückseite des Substrates ganzflächig als Masseleitung metallisiert ist und die Vorderseite schmale metallische Leiterbahnen trägt. Ebenso sind Koplanarleitungen gebräuchlich, bei denen der heiße Leiter auf beiden Seiten von zwei Masseleitern in geringem Abstand umgeben ist.

Da die auf der Oberfläche des Adaptersubstrates befindlichen Zuleitungen auf möglichst kurzen Übergängen zu den Kontakten auf dem HF-Mikrochip geführt werden müssen, ist es erforderlich, das Adaptersubstrat mit seiner Oberseite der Oberseite des Mikrochips zuzuwenden. Dabei weist die unstruktuerte Unterseite des Adaptersubstrates nach oben, wobei der Blick auf die Leiterstrukten des Adaptersubstrates verwehrt ist, was eine exakte Kontaktierung unter Sichtkontrolle erschwert. Nach dem Stand der Technik wird diese Schwierigkeit dadurch gelöst, indem man die Leiterstrukturen bis an den Substratrand heranführt und dort kleine Metallstreifen aufsetzt, die über den Substratrand herausragen und dann auch von der oben liegenden Rückseite her sichtbar sind. Diese Metallstreifen haben gleichzeitig eine Federwirkung, die erforderlich ist, um geringe Höhendifferenzen benachbarter Kontakte auszugleichen und so eine sichere Kontaktierung zu ermöglichen.

Aus der DE 39 30 621 A1 ist es bekannt, zum Einbau eines Feldeffekt-Transistor-Chips in eine Mikrostreifenleitung Beam-Leiter vorzusehen. Die Anordnung weist dielektrische Substrate auf, auf denen Leiter mit im wesentlichen gleicher Breite liegen. Die Substrate sind durch einen Spalt getrennt, in dem der Transistor-Chip angeordnet ist. Die Beam-Leiter können einstückig mit den Leitern der Mikrostreifenleitung ausgebildet sein. Zur Herstellung der Beam-Leiter wird vorgeschlagen, zunächst bereichsweise eine Photoresistschicht und dann eine Metallisierung auf einen dielektrischen Körper aufzubringen. Durch Strukturierung der Metallisierung entstehen die Mikrostreifenleiter. Dabei wird über der Photoresistschicht ein Spalt zwischen den Leitern vorgesehen. Dann wird ein Teil des Körpers, das der Photoresistschicht gegenüberliegt, z.B. durch Sägen oder Schneiden von der rückseitigen Oberfläche des Körpers entfernt. Die verbleibende Photoresistschicht wird ebenfalls entfernt. Es entstehen zwei Teile des Körpers mit über den Körper hinausragenden Beam-Leitern, die als Metallstreifen ausgebildet sind.

Nachteilig an diesen Adaptersubstraten nach dem Stand der Technik ist, daß es sehr schwierig ist, die Metallstreifen in der erforderlichen Kleinheit auf den Leitungen des Adaptersubstrates zu befestigen. Die maximale Größe der Metallstreifen ist durch den Kontaktabstand auf dem Mikrochip und durch die maximale, mit den Metallstreifen überbrückbare Länge vorgegeben. Darüberhinaus ist es nachteilig, daß im Übergangsbereich des Metallstreifens die Leitung nur einpolig vorliegt, da das umgebende Dielektrikum und die Masseleitung im Übergangsbereich nicht mitgeführt werden können.

In der EP-A1-0 001 707 ist eine Schaltungsanordnung beschrieben, bei der in einem Fenster einer Siliziumplatte thermisch isoliert über Leiterbücken Schaltungsanordnungen auf Siliziumplättchen aufgehängt sind. Die Brücken bestehen aus einer Schutzschicht, einer Klebstoffschicht mit den Eigenschaften eines elektrischen Widerstandes oder einer Schicht aus Chrom oder Titan und einer Metallschicht, beispielsweise aus rostfreiem Stahl. Diese elektrisch leitfähigen Brücken bewirken eine Wärmeisolation zwischen dem Siliziumrahmen des Fensters und den darin angeordneten Siliziumplättchen.

Die US-Patentschrift 3.747,202 befaßt sich mit einer Verbesserung des damals neu entwickelten Beam-Lead-Verfahrens. Bei diesem Verfahren werden auf der Oberfläche von Halbleiterbauelementen dicke Leiterstrukturen aufgebracht, die über den Randbereich des noch nicht vereinzelten Bauelements hinausragen. Beim Vereinzeln der Halbleiterbauelemente wird der Wafer von unten her in einem breiten Trennbereich weggeäzt, so daß die über den Chiprand hinausragenden Leiterbahnen (engl. Beam Leads) stehen bleiben. Die Chips mit den hinausragenden Leiterbahnen werden über Kopf (engl. Flip Chip) auf entsprechend strukturierte Leiterbahnen eines Substrates aufgebracht und in einem Beam-Lead-Bonder oder durch einen Lötprozeß gemeinsam mit den Substratleiterbahnen fest verbunden. Dabei wird die Separation der Beam Leads von der Waferoberfläche durch ein unterschneidendes Wegätzen einer Haftschicht unterhalb der über den Chiprand hinausragenden Teile der Beam Leads erreicht.

In der DE 28 10 054 A1 werden beamleadähnliche Anschlußzungen von einem Bauelementeträger her aufgebaut. Diese Zungen werden mit korrespondierenden Kontaktflächen auf den Bauelementen fest verbunden. Die Anschlußzungen bestehen aus einem Harzfilm mit einer darunter liegenden Befestigungsschicht und einer darüber liegenden strukturierten Verdrahtungsschicht. Diese Verdrahtungsschicht kontaktiert die Anschlußflecken auf Bauelementen durch Löcher in dem Hartfilm, deren Böschungsräder geneigt sind, um ein Abreißen der Verdrahtungsschicht zu vermeiden.

In beiden Dokumenten sind feste Verbindungen von den dort beschriebenen Anschlußstrukturen zu den Anschlußbereichen der Bauelemente beschreiben. Diese Anschlußstrukturen sollten gleichzeitig eine dauerhafte elektrische und mechanische Verbindung mit einem Trägersubstrat herstellen. Für jeden elektrischen Kanal ist hier nur ein Leiter vorgesehen, was für Gleichspannungskontakt oder auch für Verbindungen im niedrigen und mittleren Frequenzbereich ausreichend ist.

Ausführungsbeispiele der Erfindung werden anhand der Zeichnungen erläutert.

Es zeigen:
Figur 1 einen Querschnitt durch eine Anordnung zur Kontaktierung von planaren Hochfrequenzleitungen,
Figur 2 eine Aufsicht auf eine Anordnung mit Koplanarleitungen,
Figur 3 eine Aufsicht auf eine Anordnung mit Mikrostreifenleitungen,
Figur 4 ein Beispiel einer Kontaktierung,
Figur 5 einen Querschnitt durch eine Anordnung mit einer Verdickung der Dielektrikumsschicht,
Figur 6 einen Querschnitt durch eine Anordnung mit einer mechanischen Spannung im Schichtaufbau und
Figur 7 einen Querschnitt durch eine Anordnung mit einer Membran.

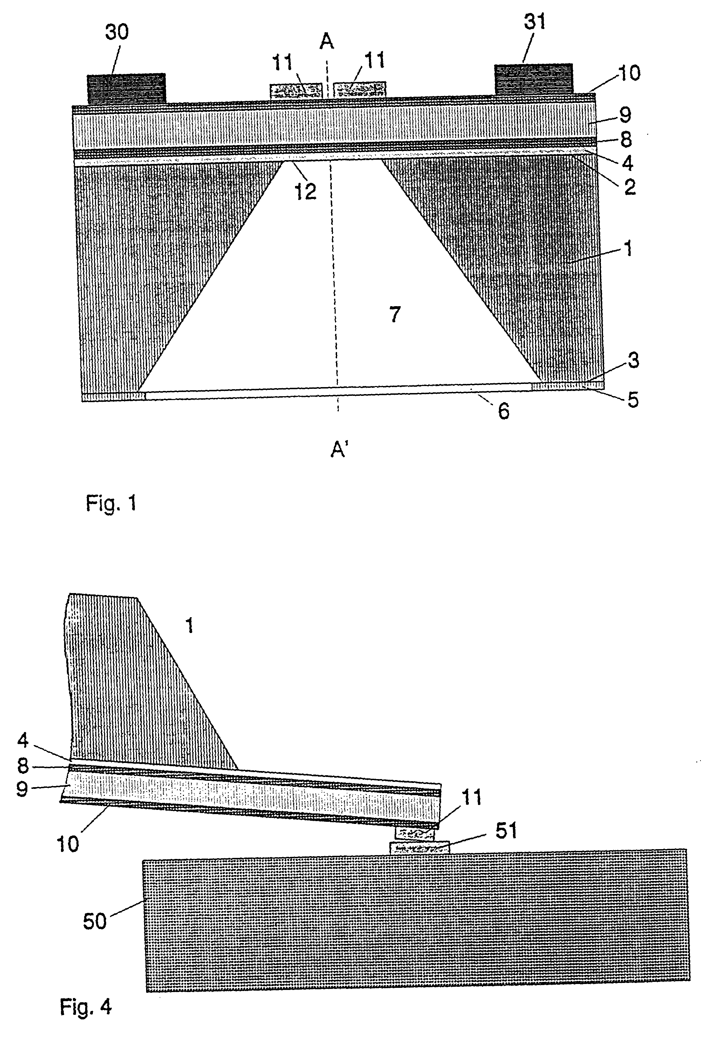

Figur 1 zeigt ein Substrat 1, hier beispielsweise aus Silizium, im Querschnitt. Das Siliziumsubstrat trägt auf seiner Oberseite 2 und auf seiner Unterseite 3 je eine Passivierungsschicht 4 bzw. 5, die beispielsweise aus je einer Doppelschicht aus Siliziumoxid und Siliziumnitrid bestehen. In der unteren Passivierungsschicht wird fotolithographisch ein Fenster 6 geöffnet, durch welches die Vertiefung 7 anisotrop geätzt wird. Hierzu ist die Kristallorientierung des Siliziumsubstrates 1 so gewählt, daß die (100)-Ebene parallel zur Substratoberfläche liegt. Die Ränder des rechteckförmigen Fensters 6 liegen dabei parallel zu den kristallographischen [110]-Richtungen. Die Vertiefung 7 wird solange geätzt, bis die Passivierungsschicht 4 auf der Substratoberseite erreicht ist. Die Seitenwände der Vertiefung 7 werden von schwer ätzbaren {111}-Ebenen gebildet.

Auf der Oberseite des Substrates wird über der Passivierungsschicht 4 eine Metallschicht 8, eine Dielektrikumsschicht 9 und eine weitere Metallschicht 10 aufgebracht. Die Metallschichten 8 und 10 können vorzugsweise aus Gold und die Dielektrikumschicht 9 aus Polyimid bestehen. Die untere Metallschicht 8 ist bis auf die Umgebung der oberen Fläche 12 der Vertiefung 7 unstruktueriert und dient als Massefläche. Innerhalb der Fensterfläche 12 wird die Metallschicht 8 bis auf die Leiterstrukturen, wie sie in der oberen Metallschicht 10 vorgesehen sind, weggeätzt. Die obere Metallschicht 10 wird fotolithographisch zur Erzeugung der Mikrostreifen bzw. Koplanarleitungen strukturiert. Im Bereich der Vertiefung sind Leiterenden oder diese überspannende Leiter vorgesehen. Diese können an den vorgesehenen Kontaktstellen zur Kontaktverbesserung metallische Kontaktflecken oder Bumps (11) aufweisen.

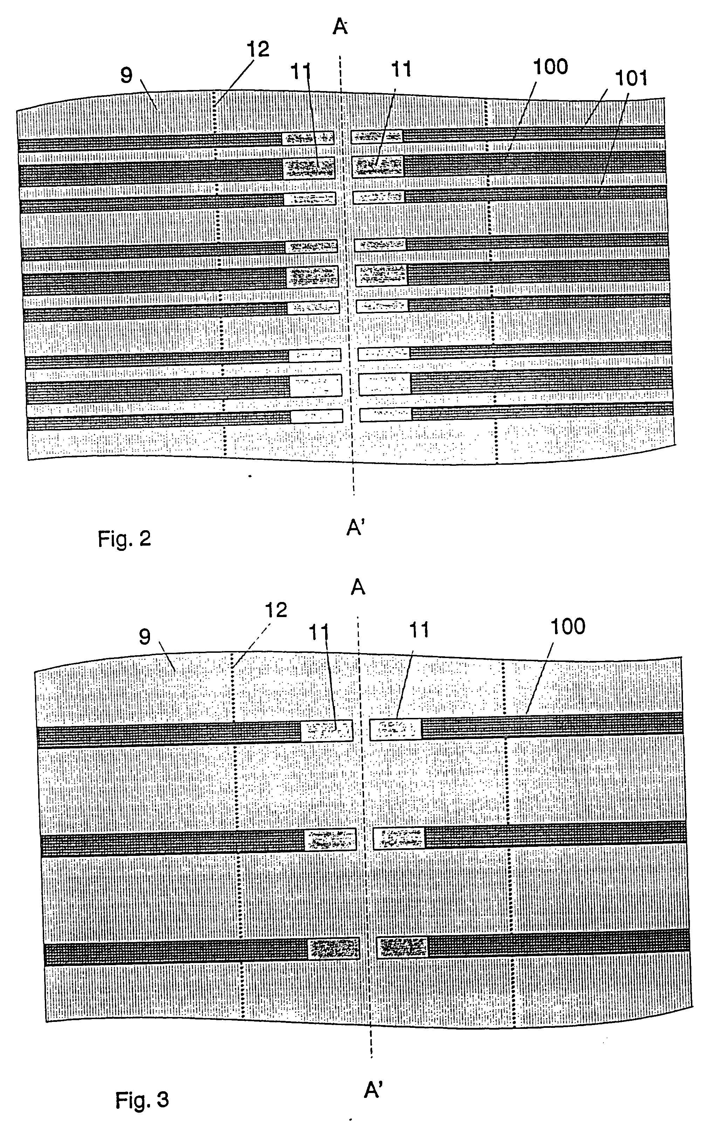

Figur 2 zeigt eine Draufsicht auf die Oberseite des Substrates, wobei die Wellenleiter als Koplanarleitungen mit der heißen Leitung 100 und den seitlichen Masseleitungen 101 ausgelegt sind.

In Figur 3 ist eine Draufsicht auf ein Substrat mit Mikrostreifen-Wellenleitern dargestellt.

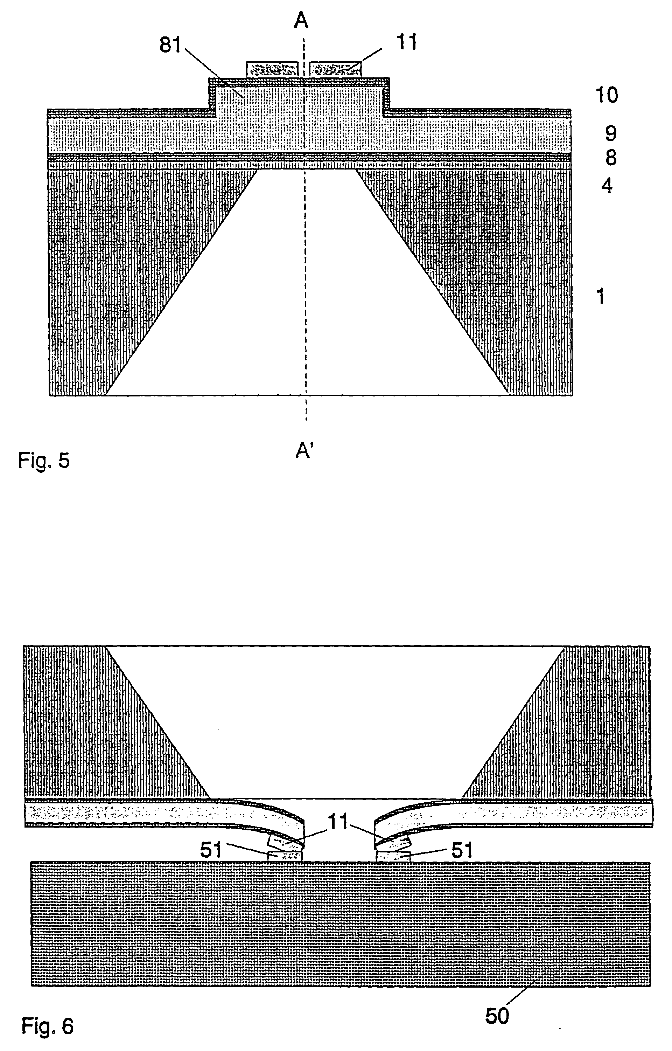

Das Substrat 1 mit den darauf befindlichen Schichten wird nach Beendigung der Strukturierung entlang der Schnittfläche A-A' durchgesägt und bei einer Fertigung mit Mehrfachnutzen vereinzelt. Man erhält bei Mehrfachnutzen pro Siliziumwafer eine Vielzahl von Anordnungen zur Kontaktierung. Eine solche Anordnung ist in Figur 4 im Einsatzfall dargestellt. Die Anordnung wird überkopf und leicht geneigt über einen Mikrochip 50 gehalten und kontaktiert dort mit dem Kontaktbump 11 den Kontakt 51 des Mikrochips.

Da die Passivierungsschicht 4 und die Polyimidschicht 9 durchsichtig sind, sind die Leiterstrukturen auf der Metallschicht 8 und der Metallschicht 10 bei Betrachtung von der bei der Anwendung obenliegenden Substratunterseite durch die durchsichtigen Schichten 4 und 9 hindurch zu sehen. Dadurch wird eine optische Justage der Leiterstrukturen zu den Kontakten auf dem Mikrochip möglich. Außerdem ist es gegenüber dem Stand der Technik vorteilhaft, daß die geätzten Seitenflächen der Vertiefung 7 geneigt verlaufen. Bei Betrachtung der Kontaktgeometrie mit einem Mikroskopobjektiv mit hoher Apertur wird hierbei das abbildende Lichtbündel nicht beschnitten.

Es ist möglich, daß auf der Oberseite des Substrates (1) noch elektronische Ansteuer- (30) und Empfängerschaltungen (31) integriert werden. Durch die kurzen Übertragungswege kann dadurch der zulässige Frequenzbereich noch weiter erhöht werden. (siehe Figur 1).

Eine andere Ausführung der erfindungsgemäßen Anordnung kann darin bestehen, daß nicht nur die Metallschichten 8 und 10, sondern auch die Passivierungsschicht 4 und die Dielektrikumschicht 9 strukturiert werden. Die mikromechanische Strukturierung von der Substratunterseite her kann vor der Beschichtung und Strukturierung der Schichten 8 bis 11 auf der Substratoberseite geschehen. Da die Passivierungsschicht 4 auf der Substratoberseite nach Durchführung der anisotropen Ätzung in KOH erhalten bleibt, bleibt auf der Oberseite eine ebene Fläche vorhanden, auf die die Schichten 4 bis 11 aufgebaut und strukturiert werden können. Durch diese Reihenfolge der Bearbeitung wird vermieden, daß die Schichten 4 bis 11 von dem Ätzmittel für die anisotrope Ätzung angegriffen werden.
Es entstehen über der Vertiefung 7 freitragende Zungen mit je mindestens einem Leiterende. Die Strukturierung der Schichten 4, 8 und 9 muß wohl an die der oberen Metallschicht angepaßt sein, die Strukturen können aber wesentlich größer oder breiter sein.
Es ist möglich in den Schichtenfolgen 4, 8, 9 und 10 gezielt mechanische Spannungen in der Art aufzubauen, daß sich die über die Vertiefung 7 hinausragenden Zungen nach oben biegen. Dadurch wird eine größere Höhe der Kontaktflecken 11 über der Substratoberfläche und zugleich eine größere Federwirkung der Kontakte erreicht.

Eine größere Höhe der Kontakte 11 über der Waferoberfläche läßt sich auch dadurch erreichen, daß das Polyimid 9 im Kontaktbereich eine Verdickung 81 erhält, wie in Figur 5 dargestellt ist.

Bei einer ausreichenden Höhe der Kontaktflächen über der Substratebene ist es nämlich nicht notwendig, daß der Meßkopf geneigt auf den zu testenden Mikrochip geführt wird, sondern die Oberfläche des Tastkopfes kann parallel zur Chipoberfläche sein. In diesem Fall kann der Tastkopf erfindungsgemäß auch so ausgestaltet sein, daß nicht nur Anschlüsse auf einer Seite des Chips möglich sind, sondern daß alle 4 Chipseiten gleichzeitig kontaktiert werden können. Ein Ausführungsbeispiel hierzu ist in Figur 6 dargestellt.

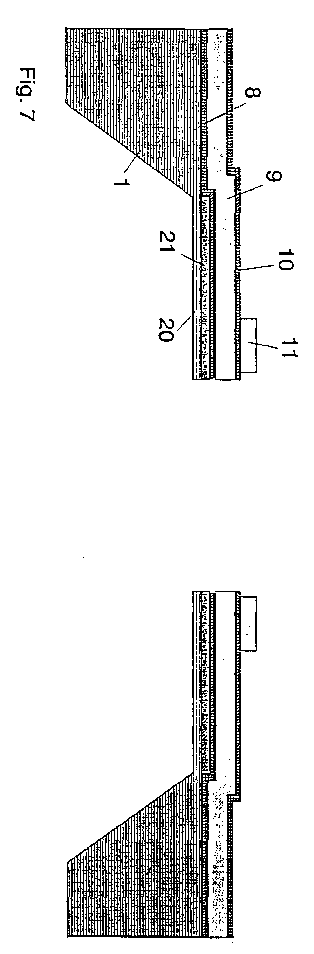

Eine andere Ausgestaltung der Erfindung wird in Figur 7 gezeigt. Die Vertiefung 7 wird zunächst nicht ganz, sondern nur bis zu einer Ätzstoppschicht nahe der Oberseite durchgeätzt. Eine solche Ätzstoppschicht läßt sich nach dem Stand der Technik durch eine erhöhte Bor-Dotierung oder durch einen eindiffundierten pn-Übergang erzeugen. Die anisotrope Ätzung stoppt selbsttätig an der Ätzstoppschicht, so daß beim Ätzen von der Unterseite her auf der Oberseite eine dünne Membran 20 zurückbleibt. Diese Membran kann nun durch isotrope oder anisotrope Ätzung von der Oberseite her zu Zungen strukturiert werden, die die Leitungsübergänge im Kontaktbereich tragen. Durch Aufbringen und Strukturieren von piezoelektrischen oder magnetostriktiven Streifen 21 auf den Zungen lassen sich diese durch Anlegen einer Steuerspannung gezielt nach oben verbiegen. Auf diese Weise ist es möglich, einzelne oder alle Kontakte eines Mikrochips wahlweise zu kontaktieren.
¹ Translator's note: there appears to be an error in the German original here. The figure 8 appears where presumably it cannot be used. It has been assumed for the purpose of the translation that the figure 7 is intended.
² There appears to be an error in the German original here. The figure 3 appears where the figure 31 seems to be intended. This has been amended accordingly in the translation.

## Patentansprüche

1. Verfahren zur Herstellung einer Anordnung zur Kontaktierung von planaren Hochfrequenzleitungen mit elektronischen Bauelementen mit folgenden Verfahrensschritten:
a) auf die Oberseite (2) und die Unterseite (3) eines Substrates (1) wird je eine Passivierungsschicht (4, 5) aufgebracht;
b) in der unteren Passivierungsschicht (5) wird ein Fenster (6) geöffnet und eine Vertiefung (7) von der Unterseite (3) ins Substrat (1) geätzt, die bis zur Passivierungsschicht (4) auf der Oberseite (2) oder bis zu einer Ätzstopschicht (20) an der Oberseite (2) reicht;
c) auf der Oberseite (2) werden über die Passivierungsschicht (4) eine untere Metallschicht (8), darüber eine Dielektrikumschicht (9) und darüber eine weitere obere Metallschicht (10) aufgebracht;
d) die obere Metallschicht (10) wird zur Erzeugung von planaren Leitermustern strukturiert, wobei im Bereich der Vertiefung (7) zumindest ein Leiter vorgesehen ist, der über der Vertiefung endet oder diese überspannt;
e) die untere Metallschicht (8) wird vor dem Aufbringen der Dielektrikumschicht (9) im Bereich der Vertiefung (7) ebenso wie die obere Metallschicht (10) strukturiert;
f) das Substrat wird derart zersägt und/oder bei einer Fertigung mit Mehrfachnutzen vereinzelt, daß über der Vertiefung freitragende Zungen mit jeweils zumindest einem Leiterende entstehen.

2. Verfahren zur Herstellung einer Anordnung zur Kontaktierung von planaren Hochfrequenzleitungen mit elektronischen Bauelementen mit folgenden Verfahrensschritten:
a) auf die Oberseite (2) und die Unterseite (3) eines Substrates (1) wird je eine Passivierungsschicht (4, 5) aufgebracht;
b) in der unteren Passivierungsschicht (5) wird ein Fenster (6) geöffnet und eine Vertiefung (7) von der Unterseite (3) ins Substrat (1) geätzt, die bis zur Passivierungsschicht (4) auf der Oberseite (2) oder bis zu einer Ätzstopschicht (20) nahe der Oberseite (2) reicht;
c) auf der Oberseite (2) werden über die Passivierungsschicht (4) eine untere Metallschicht (8), darüber eine Dielektrikumschicht (9) und darüber eine weitere obere Metallschicht (10) aufgebracht;
d) die obere Metallschicht (10) wird zur Erzeugung von planaren Leitermustern strukturiert, wobei im Bereich der Vertiefung (7) zumindest ein Leiter vorgesehen ist, der über der Vertiefung endet;
e) die untere Metallschicht (8) wird im Bereich der Vertiefung (7) ebenso wie die obere Metallschicht (10) struktuiert;
f) die Dielektrikumschicht (9) und die Passivierungsschicht (4) oder die Dielektrikumsschicht (9), die Passivierungsschicht (4) und eine noch verbleibende dünne Substratschicht über der Ätzstopschicht (20) werden im Bereich der Vertiefung (7) durch Ätzen derart strukturiert, daß die Leiterenden über der Vertiefung (7) aus freitragenden Zungen zumindest mit untere Metallschicht (8), Dielektrikumschicht (9) und Obere Metallschicht (10) bestehen.

3. Passivierungsschicht (4), untere Metallschicht (8),
Dielektrikumsschicht (9) und obere Metallschicht (10) mechanische Spannungen derart aufgebaut werden, daß sich die Zungen vom Substrat weg biegen.

4. Verfahren nach einem der Ansprüche 1 bis 3, **dadurch gekennzeichnet, daß** an den über der Vertiefung befindlichen Enden der Leiterbahnen eine Verdickung auf der Dielektrikumsschicht (9) aufgebracht wird.

5. Anordnung zur Kontaktierung von planaren
Hochfrequenzleitungen mit elektronischen Bauelementen mit folgenden Merkmalen:
a) ein Substrat (1) trägt auf seiner Oberseite (2) eine Passivierungsschicht (4), darüber eine untere Metallschicht (8), darüber eine Dielektriumschicht (9) und darüber eine weitere Obere Metallschicht (10), die entsprechend einem vorgegebenen Leitermuster strukturiert ist;
b) im Substrat (1) befindet sich eine Vertiefung (7), die von der Unterseite (3) bis zur Passivierungssschicht (4) auf der Oberseite (2) oder bis zu einer Ätzstopschicht (20) an der Oberseite (2) des Substrats (1) reicht;
c) im Bereich der Vertiefung (7) ist zumindest ein Leiter vorgesehen, der über der Vertiefung (7) endet;
d) die untere Metallschicht (8) ist im Bereich der Vertiefung (7) ebenso wie die obere Metallschicht (10) strukturiert.

6. Anordnung zur Kontaktierung von planaren
Hochfrequenzleitungen mit elektronischen Bauelementen mit folgenden Merkmalen:
a) ein Substrat (1) trägt auf seiner Oberseite (2) eine Passivierungsschicht (4), darüber eine untere Metallschicht (8), darüber eine Dielektriumschicht (9) und darüber eine weitere Obere Metallschicht (10), die entsprechend einem vorgegebenen Leitermuster strukturiert ist;
b) an einem Rand des Substrats (1) befindet sich ein abgesetzter Bereich (7), der von der Unterseite (3) bis zur Passivierungssschicht (4) auf der Oberseite (2) oder bis zu einer Ätzstopschicht (20) an der Oberseite (2) des Substrats (1) reicht;
c) über dem abgesetzten Bereich (7) endet zumindest ein Leiter;
d) die untere Metallschicht (8) ist über dem abgesetzten Bereich (7) ebenso wie die obere Metallschicht (10) strukturiert.

7. Anordnung nach Anspruch 6, **dadurch gekennzeichnet, daß** auf den Leiterenden am Rand des Substrates (1) zusätzliche metallische Kotaktflächen (11) vorgesehen sind.

8. Anordnung nach einem der Ansprüche 5 bis 8, **dadurch gekennzeichnet, daß** auf der Oberseite des Substrates (1) elektronische Ansteuer- (30) oder Empfängerschaltungen (3) vorgesehen sind.

9. Anordnung nach einem der Ansprüche 5 bis 8, **dadurch gekennzeichnet, daß** sich der über die Vertiefung (7) bzw. über den abgesetzten Bereich überstehende Teil mit Leiter und Dielektrikumsschicht (9) vom Substrat (1) weg biegt.

## Claims

1. Method for making a contact device for planar high frequency leads with electronic components with the following process steps:
a) a passivation layer (4, 5) is applied both to the upper side (2) and the under side (3) of a substrate (1);
b) a window (6) is opened in the lower passivation layer (5) and a depression (7) etched from the underside (3) into the substrate (1), reaching as far as the passivation layer (4) on the upper side (2) or as far as an etch stop layer (20) on the upper side (2);
c) on the upper side (2), over the passivation layer (4), a lower metal layer (8), over that a dielectric layer (9) and over that a further upper metal layer (10) are applied;
d) the upper metal layer (10) is patterned for the creation of planar lead patterns, whereby in the region of the depression (7) at least one lead is provided that ends over the depression or spans it;
e) the lower metal layer (8) is also structured before application of the dielectric layer (9) in the region of the depression (7) just like the upper metal layer (10);
f) the substrate is sawn in such a manner and/or separated, in the case of multiple printed panel production, that cantilever tongues each with at least one lead end arise over the depression.

2. Method for making a contact device for planar high frequency leads with electronic components with the following process steps:
a) a passivation layer (4, 5) is applied both to the upper side (2) and the under side (3) of a substrate (1);
b) a window (6) is opened in the lower passivation layer (5) and a depression (7) etched from the underside (3) into the substrate (1), reaching as far as the passivation layer (4) on the upper side (2) or as far as an etch stop layer (20) on the upper side (2);
c) on the upper side (2), over the passivation layer (4), a lower metal layer (8), over that a dielectric layer (9) and over that a further upper metal layer (10) are applied;
d) the upper metal layer (10) is patterned for the creation of planar lead patterns, whereby in the region of the depression (7) at least one lead is provided that ends over the depression;
e) the lower metal layer (8) is also structured in the region of the depression (7) just like the upper metal layer (10);
f) the dielectric layer (9) and the passivation layer (4) or the dielectric layer (9), the passivation layer (4) and a still remaining thin substrate layer over the etch stop layer (20) are so patterned by etching in the region of the depression (7) that the lead ends over the depression (7) comprise cantilever tongues at least with lower metal layer (8), dielectric layer (9) and an upper metal layer (10).

3. Method according to one of the claims 1 or 2,
**characterised in that**
in the layer sequence comprising passivation layer (4), lower metal layer (8), dielectric layer (9) and upper metal layer (10) mechanical tensions are built up such that the tongues bend away from the substrate.

4. Method according to one of the claims 1 to 3,
**characterised in that**
on the ends of the conductor tracks situated over the depression, a thickening is applied to the dielectric layer (9).

5. Contact device for planar high frequency leads with electronic components with the following features:
a) a substrate (1) carries on its upper side (2) a passivation layer (4), over that a lower metal layer (8), over that a dielectric layer (9) and over that a further upper metal layer (10) patterned according to a predetermined lead pattern;
b) in the substrate (1) there is a depression (7) extending from the underside (3) to the passivation layer (4) on the upper side (2) or to an etch stop layer (20) on the upper side (2) of the substrate (1);
c) in the region of the depression (7), at least one lead is provided, which ends over the depression (7);
d) the lower metal layer (8) is structured in the region of the depression (7) just like the upper metal layer (10).

6. Contact device for planar high frequency leads with electronic components with the following features:
a) a substrate (1) bears on its upper side (2) a passivation layer (4), over that a lower metal layer (8), over that a dielectric layer (9) and over that a further upper metal layer (10), patterned according to a predetermined lead pattern;
b) on one edge of the substrate (1) is situated a recessed region (7) extending from the underside (3) to the passivation layer (4) on the upper side (2) or to an etch stop layer (20) on the upper side (2) of the substrate (1);
c) at least one lead ends over the recessed region (7);
d) the lower metal layer (8) is patterned over the recessed region (7) just like the upper metal layer (10).

7. Device according to Claim 6,
**characterised in that**
on the lead ends at the edge of the substrate (1), additional metallic contact surfaces (11) are provided.

8. Device according to one of the claims 5 to 8¹,
**characterised in that**
on the upper side of the substrate (1), electronic driver circuits (30) or receiver circuits (31)² are provided.

9. Device according to one of the claims 5 to 8,
**characterised in that**
the part with lead and dielectric layer (9) protruding over the depression (7) or over the recessed region bends away from the substrate (1).

## Revendications

1. Procédé de fabrication d'un dispositif de contact de lignes planaires à haute fréquence avec des composants électroniques avec les étapes de procédé suivantes :
a) sur la face supérieure (2) et la face inférieure (3) d'un substrat (1), on applique une couche de passivation (4, 5) ;
b) dans la couche de passivation (5) inférieure, on ouvre une fenêtre (6) et on décape une cavité (7) à partir de la face inférieure (3) dans le substrat (1), qui va jusqu'à la couche de passivation (4) sur la face supérieure (2) ou jusqu'à une couche d'arrêt de décapage (20) sur la face supérieure (2) ;
c) sur la face supérieure (2), on applique au-dessus de la couche de passivation (4) une couche inférieure de métal (8), par-dessus une couche diélectrique (9) et par-dessus une autre couche supérieure de métal (10) ;
d) la couche supérieure de métal (10) est structurée pour l'obtention de modèles de conducteurs planaires, en prévoyant au moins un conducteur dans la zone de la cavité (7) qui se termine au-dessus de la cavité ou passe au-dessus ;
e) la couche inférieure de métal (8) est structurée de la même façon que la couche supérieure de métal (10) avant l'application de la couche diélectrique (9) dans la zone de la cavité (7) ;
f) le substrat est scié et/ou isolé dans le cas d'une fabrication avec flan imprimé multiple de telle façon que des lames en saillie avec au moins une extrémité de conducteur à chaque fois se forme au-dessus de la cavité.

2. Procédé de fabrication d'un dispositif de contact de lignes planaires à haute fréquence avec des composants électroniques comprenant les étapes de procédé suivantes:
a) on applique une couche de passivation (4,5) sur la face supérieure (2) et la face inférieure (3) d'un substrat (1) ;
b) dans la couche inférieure de passivation (5), on ouvre une fenêtre (6) et on décape une cavité (7) à partir de la face inférieure (3) dans le substrat (1), qui va jusqu'à la couche de passivation (4) sur la face supérieure (2) ou jusqu'à une couche d'arrêt de décapage (20) à proximité de la face supérieure (2) ;
c) sur la face supérieure (2), on applique au-dessus de la couche de passivation (4) une couche inférieure de métal (8), au-dessus une couche diélectrique (9) et par-dessus une autre couche supérieure de métal (10) ;
d) la couche supérieure de métal (10) est structurée pour générer des modèles de conducteurs planaires en prévoyant dans la zone de la cavité (7) au moins un conducteur qui se termine au-dessus de la cavité ;
e) la couche inférieure de métal (8) est structurée de la même façon que la couche supérieure de métal (10) dans la zone de la cavité (7) ;
f) la couche diélectrique (9) et la couche de passivation (4) ou la couche diélectrique (9), la couche de passivation (4) et une couche de substrat mince résiduelle au-dessus de la couche d'arrêt de décapage (20) sont structurées dans la zone de la cavité (7) par décapage de telle façon que les extrémités de conducteurs au-dessus de la cavité (7) comprennent des lames en saillie au moins avec une couche inférieure de métal (8), une couche diélectrique (9) et une couche supérieure de métal (10).

3. Procédé selon l'une quelconque des revendications 1 ou 2, **caractérisé en ce que**, dans la séquence de couche comprenant la couche de passivation (4), la couche inférieure de métal (8), la couche diélectrique (9) et la couche supérieure de métal (10), des tensions mécaniques sont établies de façon que les lames se plient en s'éloignant du substrat.

4. Procédé selon l'une quelconque des revendications 1 à 3, **caractérisé en ce qu'**une surépaisseur est appliquée sur la couche diélectrique (9) sur les extrémités des pistes conductrices qui se trouvent au-dessus de la cavité.

5. Dispositif de contact de lignes planaires à haute fréquence avec des composants électroniques comprenant les caractéristiques suivantes :
a) un substrat (1) porte sur sa face supérieure (2) une couche de passivation (4), au-dessus une couche inférieure de métal (8), au-dessus une couche diélectrique (9) et par-dessus une autre couche de métal (10) supérieure, qui est structurée en fonction d'un modèle de conducteur prédéfini ;
b) dans le substrat (1) se trouve une cavité (7) qui va de la face inférieure (3) jusqu'à la couche de passivation (4) sur le dessus (2) ou jusqu'à une couche d'arrêt de décapage (20) sur la face supérieure (2) du substrat (1) ;
c) dans la zone de la cavité (7), il est prévu au moins un conducteur qui se termine au-dessus de la cavité (7) ;
d) la couche inférieure de métal (8) est structurée de la même façon que la couche supérieure de métal (10) dans la zone de la cavité (7).

6. Dispositif de contact de lignes planaires à haute fréquence avec des composants électroniques présentant les caractéristiques suivantes :
a) un substrat (11) porte sur sa face supérieure (2) une couche de passivation (4), au-dessus une couche inférieure de métal (8), au-dessus une couche diélectrique (9) et par-dessus une autre couche de métal (10) supérieure, qui est structurée en fonction d'un modèle de conducteur prédéfini ;
b) sur un bord du substrat (1) se trouve une zone (7) décalée, qui va de la face inférieure (3) jusqu'à la couche de passivation (4) sur la face supérieure (2) ou jusqu'à une couche d'arrêt de décapage (20) sur la face supérieure (2) du substrat (1) ;
c) au moins un conducteur se termine au-dessus de la zone (7) décalée ;
d) la couche de métal (8) inférieure est structurée au-dessus de la zone (7) décalée de la même façon que la couche supérieure de métal (10).

7. Dispositif selon la revendication 6, **caractérisé en ce que** des surfaces de contact (11) métalliques supplémentaires sont prévues sur les extrémités de conducteur sur le bord du substrat (1).

8. Dispositif selon l'une quelconque des revendications 5 à 8, **caractérisé en ce que** des circuits électroniques de commande (30) ou récepteurs (3) sont prévus sur la face supérieure du substrat (1).

9. Dispositif selon l'une quelconque des revendications 5 à 8, **caractérisé en ce que** la partie supérieure débordant de la cavité (7) ou de la zone décalée avec le conducteur et la couche diélectrique (9) se plie à partir du substrat (1).
